# EUROPEAN PATENT SPECIFICATION

(11) **EP 3 958 292 B1**
(45) Date of publication and mention of the grant of the patent: **02.04.2025**
(21) Application number: 20790911.0
(22) Date of filing: 07.04.2020
(51) Int. Cl.: C11D 7/32, C11D 7/50, C11D 17/00, H01L 21/02

(54) **CLEANING FLUID, METHOD OF CLEANING, AND METHOD OF PREPARING SEMICONDUCTOR WAFER**
REINIGUNGSFLÜSSIGKEIT, VERFAHREN ZUR REINIGUNG, VERFAHREN ZUR HERSTELLUNG EINER HALBLEITERSCHEIBE
FLUIDE DE NETTOYAGE, PROCÉDÉ DE NETTOYAGE, PROCÉDÉ DE PRÉPARATION DE TRANCHE DE SEMI-CONDUCTEUR

(30) Priority: 15.04.2019 JP 2019076762
(43) Date of publication of application: 23.02.2022
(73) Proprietor: Mitsubishi Chemical Corporation, Chiyoda-ku Tokyo 100-8251 (JP)
(72) Inventor: SHIBATA, Toshiaki, Tokyo 100-8251 (JP); KAWASE, Yasuhiro, Tokyo 100-8251 (JP)
(74) Representative: Hoffmann Eitle
(86) International application number: PCT/JP2020/015752
(87) International publication number: WO 2020/213487

(56) References cited:
- WO-A1-2018/111545
- WO-A1-2018/168207
- JP-A- 2001 345 303
- JP-A- 2014 132 641
- JP-A- 2018 199 767
- US-A1- 2011 034 037
- US-B1- 6 228 823

## Description

### TECHNICAL FIELD

The present invention relates to a cleaning fluid, a method of cleaning, and a method of preparing a semiconductor wafer.

### BACKGROUND ART

In recent years, in a semiconductor device production process, the demand for cleaning the surface of a semiconductor wafer has become stricter with the increase in speed and integration of the semiconductor device. Generally, in order to clean the surface of the semiconductor wafer, cleaning using a cleaning fluid is performed. In particular, cleaning the surface of the semiconductor wafer is very important because various pollutants that deteriorate characteristics of the semiconductor device remain on the surface of the semiconductor wafer after the polishing steps.

As a cleaning fluid used in a cleaning step after the polishing steps in the semiconductor device production process, for example, Patent Literature 1 discloses a cleaning fluid containing a surfactant. Patent Literature 2 describes a surface processing agent which contains an organic alkaline and a complexing agent, and further a surfactant, and it is used to clean a substrate having a transition metal or a transition metal compound on its surface. Patent Literature 3 describes a surface treatment composition that comprises a liquid medium containing at least two different complexing agents as a metal deposition preventive.

### CITATION LIST

### PATENT LITERATURE

Patent Literature 1: JP-A-2003-289060
Patent Literature 2: JP-A-2001-345303
Patent Literature 3: US 6 228 823 B1

### SUMMARY OF INVENTION

### TECHNICAL PROBLEM

In the polishing step represented by a chemical mechanical polishing (hereinafter, may be abbreviated as "CMP") step or a backgrinding step, since metal components, abrasive fine particles, and the like remain on the surface of the semiconductor wafer, there is a problem that the characteristics of the semiconductor device are deteriorated.

The residual metal components, abrasive fine particles, and the like are to be cleaned with a cleaning fluid. However, when the cleaning fluid is an acidic aqueous solution, the abrasive fine particles represented by colloidal silica are positively charged in the aqueous solution, the surface of the semiconductor wafer is negatively charged, an electrical attraction acts, and there is a problem that it is difficult to remove the abrasive fine particles. In contrast, when the cleaning fluid is an alkaline aqueous solution, hydroxide ions are abundantly present in the aqueous solution, so that both the abrasive fine particles represented by colloidal silica and the surface of the semiconductor wafer are negatively charged, and an electrical repulsive force acts, making the removal of the abrasive fine particle easy.

In addition, it is conceivable to use a cleaning fluid containing a surfactant to remove residual metal components, abrasive fine particles, and the like. However, there is a problem that the abrasive fine particles to which an organic compound is adhered coordinate with the surfactant, making it difficult for the organic compound to dissolve in the cleaning fluid, and making it difficult to remove the abrasive fine particles. And there is also a problem that the surfactant itself tends to remain on the surface of the semiconductor wafer, causing deterioration of the characteristics of the semiconductor device. Since the cleaning fluid disclosed in Patent Literature 1 contains a surfactant, the fine particle removal property is poor.

The present invention has been made in view of such a problem, and an object of the present invention is to provide a cleaning fluid excellent in metal removal property and fine particle removal property without corroding silicon. Another object of the present invention is to provide a method of cleaning excellent in metal removal property and fine particle removal property without corroding silicon.

### SOLUTION TO PROBLEM

Previously, cleaning fluids containing various components have been studied. As a result of intensive studies, the present inventors have found a cleaning fluid that combines the following components (A) to (C), and have further found that this cleaning fluid is excellent in metal removal property and fine particle removal property without corroding silicon.

Namely, the present invention is directed to a cleaning fluid containing the following components (A) to (C) and 0.001 mass% or less of surfactant:
Component (A): a compound represented by the following general formula (1)
Component (B): an alkaline compound
Component (C): water

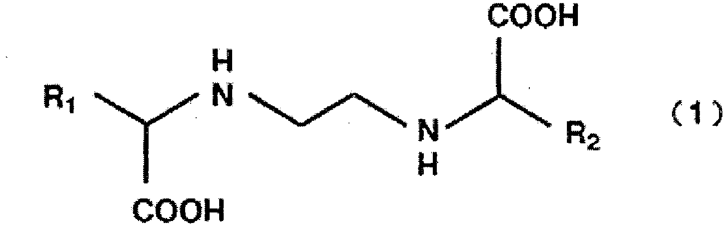

In the general formula (1), R₁ and R₂ each independently represent a hydroxyl group or a phenol group. The cleaning fluid comprises 0.0001 mass% to 10 mass% of the component (A) and 0.001 mass% to 50 mass% of the component (B) based on 100 mass% of the cleaning fluid.

Additionally, the present invention is directed to a method of cleaning a semiconductor wafer comprising the step of cleaning the semiconductor wafer with the cleaning.

Furthermore, the present invention is directed to a method of preparing a semiconductor wafer containing cleaning the semiconductor wafer with the cleaning fluid.

### ADVANTAGEOUS EFFECTS OF INVENTION

The cleaning fluid and the method of cleaning of the present invention are excellent in metal removal property and fine particle removal property without corroding silicon.

In addition, since the method of preparing a semiconductor wafer of the present invention includes a cleaning step excellent in metal removal property and fine particle removal property without corroding silicon, malfunction of the semiconductor device can be prevented.

### DESCRIPTION OF EMBODIMENTS

Hereinafter, embodiments of the present invention are specifically described, but it should not be construed that the present invention is limited to the following embodiments, and the present invention can be carried out by making various changes within the scope of the appended claims. In the present description, the expression "to" is used as an expression including numerical values or physical property values before and after the expression.

### (Cleaning Fluid)

A cleaning fluid of the present invention (hereinafter, may be simply referred to as "cleaning fluid") includes a cleaning fluid according to a first embodiment of the present invention and a cleaning fluid according to a second embodiment of the present invention.

The cleaning fluid according to the first embodiment of the present invention contains the following components (A) to (C) and 0.001 mass% or less of a surfactant.

Component (A): a compound represented by the following general formula (1)
Component (B): alkaline compound
Component (C): water

The cleaning fluid comprises 0.0001 mass% to 10 mass% of the component (A) and 0.001 mass% to 50 mass% of the component (B) based on 100 mass% of the cleaning fluid

Since the cleaning fluid contains 0.001 mass% or less of a surfactant, abrasive fine particles can be prevented from coordinating with the surfactant and difficulty in removing the abrasive fine particle can be prevented in polishing steps. The cleaning fluid contains preferably 0.0001 mass% or less of the surfactant, more preferably 0.00001 mass% or less of the surfactant, and still more preferably 0 mass% of the surfactant.

The cleaning fluid according to the second embodiment of the present invention contains the above components (A) to (C) and substantially no surfactant. The expression "the cleaning fluid contains substantially no surfactant" means that the cleaning fluid contains 0 mass% to 0.00001 mass% of the surfactant in 100 mass% of the cleaning fluid.

When the cleaning fluid contains substantially no surfactant, the abrasive fine particles can be prevented from coordinating with the surfactant and the difficulty in removing the abrasive fine particle can be prevented in the polishing steps.

The surfactant is a substance having a hydrophilic group and a lipophilic group (hydrophobic group) in the molecule. Examples of the surfactant include alkyl sulfonic acids and salts thereof, alkylbenzene sulfonic acids and salts thereof, alkyldiphenyl ether disulfonic acids and salts thereof, alkylmethyl tauric acids and salts thereof, sulfosuccinic acid diesters and salts thereof, and polyoxyalkylene alkyl ethers and salts thereof.

### (Component (A))

The component (A) is a compound represented by the following general formula (1).

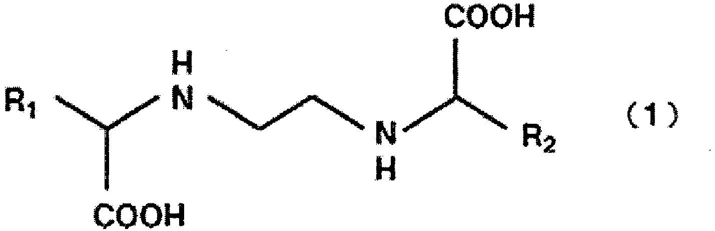

In the general formula (1), R₁ and R₂ each independently represent a hydroxyl group or a phenol group.

When the cleaning fluid of the present invention contains the component (A), an amino group, a carboxyl group and a hydroxyl group in the structure of the component (A) makes covalent coordinate bonds with a metal ion to capture the metal ion remaining on the surface of a semiconductor wafer and help to dissolve it in the cleaning fluid. Therefore, the cleaning fluid of the present invention is excellent in metal removal property.

In the general formula (1), R₁ and R₂ each independently represent a hydroxyl group or a phenol group. From the viewpoint that the cleaning fluid is excellent in metal removal property, it is preferable that both R₁ and R₂ are hydroxyl groups, or both R₁ and R₂ are phenol groups, and it is more preferable that both R₁ and R₂ are phenol groups.

The phenol group may be any one containing a phenyl group and a hydroxyl group, and the number of hydroxyl groups may be singular or plural. The phenyl group may have a substituent other than the hydroxyl group.

Specific examples of the component (A) include ethylenediamine di-o-hydroxyphenyl acid, ethylenediamine-N,N'-bis[(2-hydroxy-5-methylphenyl) acetic acid], ethylenediamine-N,N'-bis[(2-hydroxy-5-chlorophenyl) acetic acid], and ethylenediamine-N,N'-bis[(2-hydroxy-5-sulfophenyl) acetic acid]. These components (A) may be used alone or in combination of two or more thereof.

Among these components (A), from the viewpoint that the cleaning fluid is excellent in fine particle removal property and metal removal property, ethylenediamine di-o-hydroxyphenyl acid and ethylenediamine-N,N'-bis[(2-hydroxy-5-sulfophenyl) acetic acid] are preferred, and ethylenediamine di-o-hydroxyphenyl acid is more preferred.

### (Component (B))

The component (B) is an alkaline compound.

When the cleaning fluid of the present invention contains the component (B), hydroxide ions can be abundantly present in the cleaning fluid, and both the abrasive fine particles represented by colloidal silica and the surface of the semiconductor wafer are negatively charged. Therefore, an electric repulsive force acts, and the cleaning fluid of the present invention is excellent in fine particle removal property.

Examples of the component (B) include an inorganic alkali and an organic alkali. These components (B) may be used alone or in combination of two or more thereof.

Among these components (B), from the viewpoint that the cleaning fluid is excellent in fine particle removal property, ammonia and a quaternary ammonium hydroxide are preferred, and ammonia, tetraethylammonium hydroxide, trishydroxyethylmethylammonium hydroxide, tetrabutylammonium hydroxide, triethylmethylammonium hydroxide, diethyldimethylammonium hydroxide, and diethylmethylpropylammonium hydroxide are more preferred; from the viewpoint that the cleaning fluid is excellent in metal removal property, ammonia and tetraethylammonium hydroxide are still more preferred; and from the viewpoint that the cleaning fluid is excellent in iron removal property, ammonia is particularly preferred.

### (Component (C))

The component (C) is water.

When the cleaning fluid of the present invention contains the component (C), the cleaning fluid is excellent in metal removal property and fine particle removal property.

Examples of the water include ion exchange water, distilled water, and ultrapure water. Among these, ultrapure water is preferred from the viewpoint of further enhancing the metal removal property and the fine particle removal property.

The cleaning fluid of the present invention preferably does not contain other components other than the components (A) to (C), but may contain a small amount of other components as long as the effect of the present invention is not influenced. The cleaning fluid contains preferably 0.001 mass% or less of other components in 100 mass% of the cleaning fluid, and more preferably the cleaning fluid contains substantially no other components. The expression "the cleaning fluid contains substantially no other components" means that the cleaning fluid contains 0 mass% to 0.00001 mass% of other components in 100 mass% of the cleaning fluid.

### (Physical Properties of Cleaning Fluid)

The pH of the cleaning fluid is preferably 9 to 14, more preferably 10 to 13, and still more preferably 11 to 12. When the pH of the cleaning fluid is larger than or equal to the lower limit value, the cleaning fluid is more excellent in fine particle removal property. When the pH of the cleaning fluid is smaller than or equal to the upper limit value, the degree of freedom in selecting the type of compounding component and setting the compounding ratio is high in the cleaning fluid, the content of the component (B) in the cleaning fluid can be lowered, and the raw material cost of the cleaning fluid can be reduced.

### (Mass Ratio of Components of Cleaning Fluid)

The mass ratio of the component (A) to the component (B) (mass of component (A)/mass of component (B)) is preferably 0.001 to 0.5, and more preferably 0.003 to 0.2. When the ratio is larger than or equal to the lower limit value, the cleaning fluid is more excellent in metal removal property. When the ratio is smaller than or equal to the upper limit value, the cleaning fluid is more excellent in fine particle removal property.

### (Content of Each Component in Cleaning Fluid)

The cleaning fluid contains 0.0001 mass% to 10 mass% of the component (A), preferably 0.0005 mass% to 6 mass% of the component (A), and more preferably 0.001 mass% to 1 mass% of the component (A) in 100 mass% of the cleaning fluid. When the content of the component (A) is larger than or equal to the lower limit value, the cleaning fluid is more excellent in metal removal property. When the content of the component (A) is smaller than or equal to the upper limit value, the cleaning fluid is more excellent in fine particle removal property.

The cleaning fluid contains 0.001 mass% to 50 mass% of the component (B), preferably 0.005 mass% to 30 mass% of the component (B), and more preferably 0.01 mass% to 5 mass% of the component (B) in 100 mass% of the cleaning fluid. When the content of the component (B) is larger than or equal to the lower limit value, the cleaning fluid is more excellent in fine particle removal property. When the content of the component (B) is smaller than or equal to the upper limit value, the pH of the cleaning fluid can be adjusted without impairing the effect of the present invention.

The content of the component (C) is preferably the balance of the components (component (A) and component (B)) other than the component (C).

### (Method of Preparing Cleaning Fluid)

The method of preparing the cleaning fluid of the present invention is not particularly limited, and the cleaning fluid can be produced by mixing the components (A) to (C).

The order of mixing is not particularly limited, and all the components may be mixed at one time, or some components may be mixed in advance and then the remaining components may be mixed.

In the method of preparing the cleaning fluid of the present invention, each component may be blended to have a content suitable for cleaning, or a cleaning fluid containing each component other than the component (C) may be prepared at a high content, and then the cleaning fluid may be prepared by diluting with the component (C) before cleaning since transportation and storage costs can be reduced.

The dilution ratio can be appropriately set depending on an object to be cleaned, and is preferably 20 times to 160 times, and more preferably 40 times to 120 times.

### (Object to be Cleaned)

Examples of the object to be cleaned of the cleaning fluid of the present invention include semiconductor wafers such as semiconductors, glass, metals, ceramics, resins, magnetic materials, and superconductors. Among these objects to be cleaned, a semiconductor wafer having a surface where a silicon-containing compound is exposed is preferred and a silicon wafer is more preferred since the metal component and the abrasive fine particles can be removed by cleaning in a short time.

The cleaning fluid of the present invention can also be suitably used for a semiconductor wafer having a surface where a metal or a metal-containing compound is exposed, because of being excellent in fine particle removal property even for the surface of the metal.

Examples of the metal include tungsten, copper, titanium, chromium, cobalt, zirconium, hafnium, molybdenum, ruthenium, gold, platinum, and silver. Examples of the metal-containing compound include nitrides of the above metals and silicides of the above metals. Among these metals and metal compounds, tungsten is preferred from the viewpoint that the cleaning fluid is excellent in fine particle removal property.

### (Types of Cleaning Step)

The cleaning fluid of the present invention is used after the polishing steps because of being excellent in metal removal property and fine particle removal property without corroding silicon.

Examples of the polishing step include a chemical mechanical polishing (CMP) step and a backgrinding step. Among these polishing steps, the CMP step and the backgrinding step are preferred from the viewpoint of the necessity of metal removal and fine particle removal after polishing, and the backgrinding step is more preferred from the viewpoint of the necessity of metal removal after polishing.

### (CMP Step)

The CMP step refers to a step of mechanically processing and planarizing the surface of the semiconductor wafer. In general, in the CMP step, using a dedicated device, a back side of the semiconductor wafer is attached to a jig referred to as a platen, and the surface of the semiconductor wafer is pressed against a polishing pad, and a polishing slurry containing abrasive fine particles is dropped onto the polishing pad to polish the surface of the semiconductor wafer.

The CMP is performed by rubbing the object to be polished against the polishing pad, using a polishing slurry.

Examples of the polishing slurry include abrasive fine particles such as colloidal silica (SiO₂), fumed silica (SiO₂), alumina (Al₂O₃), and ceria (CeO₂). These abrasive fine particles are the main cause of fine particle contamination of the object to be polished. However, the cleaning fluid of the present invention has a function of removing fine particles adhering to the object to be polished, dispersing the fine particles in the cleaning fluid, and preventing re-adhesion, and thus exhibits a high effect in removing fine particle contamination.

The polishing slurry may contain additives such as an oxidizing agent and a dispersant in addition to the abrasive fine particles.

### (Backgrinding Step)

The backgrinding step is a semiconductor wafer thinning process to a predetermined thickness, after forming a pattern on the surface of the semiconductor wafer such that it can be packaged at a high density. **In** general, in the backgrinding step, a diamond wheel is used to grind and polish the surface of the semiconductor wafer.

Since the processing device used in the backgrinding step is made of various metals, the surface of the semiconductor wafer is contaminated with various metals. For example, the surface of the semiconductor wafer is contaminated with iron, nickel, etc. from stainless steel members, and the surface of the semiconductor wafer is contaminated with aluminum, calcium, etc. from semiconductor wafer holders. Since the malfunction of the semiconductor device is caused by these contaminations, cleaning with the cleaning fluid of the present invention excellent in metal removal property is of great significance.

### (Cleaning Conditions)

The method of cleaning the object to be cleaned is preferably a method of bringing the cleaning fluid of the present invention into direct contact with the object to be cleaned.

Examples of the method of bringing the cleaning fluid of the present invention into direct contact with the object to be cleaned include: a dipping method of immersing the object to be cleaned in a cleaning tank filled with the cleaning fluid of the present invention; a spin method of rotating the object to be cleaned at a high speed while flowing from a nozzle the cleaning fluid of the present invention onto the object to be cleaned; and a spray method of spraying the cleaning fluid of the present invention onto the object to be cleaned for cleaning. Among these methods, the spin method and the spray method are preferred since more efficient contamination elimination can be performed in a short time.

Examples of an apparatus for performing such cleaning include a batch cleaning apparatus for simultaneously cleaning a plurality of objects to be cleaned, which are accommodated in a cassette, and a single-wafer cleaning apparatus for mounting a single object to be cleaned on a holder and performing cleaning. Among these apparatuses, the single-wafer cleaning apparatus is preferred since the cleaning time can be shortened and the use of the cleaning fluid of the present invention can be reduced.

As the method of cleaning for an object to be cleaned, the method of cleaning by means of physical force is preferred since the removal property for fine particles adhered to the object to be cleaned can be further improved and the cleaning time can be shortened, scrub cleaning using a cleaning brush and ultrasonic cleaning at a frequency of 0.5 megahertz or more are more preferred, and scrub cleaning using a resin brush is still more preferred because of being more suitable for cleaning after the CMP step and the backgrinding step.

The material of the resin brush is not particularly limited, and polyvinyl alcohol and polyvinyl formal are preferred since the resin brush itself can be easily produced.

The cleaning temperature may be room temperature of 20°C to 30°C, and may be 30°C to 70°C by heating as long as the performance of the semiconductor wafer is not impaired.

### (Method of Cleaning)

The method of cleaning of the present invention is a method including cleaning a semiconductor wafer with the cleaning fluid of the present invention, and the method including cleaning a semiconductor wafer with the cleaning fluid of the present invention is as described above.

### (Method of Preparing Semiconductor Wafer)

The method of preparing a semiconductor wafer of the present invention is a method including cleaning a semiconductor wafer with the cleaning fluid of the present invention, and the method including cleaning a semiconductor wafer with the cleaning fluid of the present invention is as described above.

The method of preparing a semiconductor wafer of the present invention preferably further includes thinning the semiconductor wafer. As thinning the semiconductor wafer, the backgrinding step described above may be used, and in this step, it is preferable to thin the semiconductor wafer to a thickness of 100 µm or less.

### Examples

Hereinafter, the present invention is demonstrated further more concretely by ways of Examples.

### (Raw Materials)

Component (A-1): ethylenediamine di-o-hydroxyphenyl acid (manufactured by Tokyo Chemical Industry Co., Ltd.)
Component (A'-1): ethylenediamine tetraacetic acid (manufactured by FUJIFILM Wako Pure Chemical Corporation)
Component (B-1): ammonia (manufactured by Tokyo Chemical Industry Co., Ltd.)
Component (B-2): tetraethylammonium hydroxide (manufactured by Tokyo Chemical Industry Co., Ltd.)
Component (X-1): polyoxyethylene lauryl ether (manufactured by Tokyo Chemical Industry Co., Ltd.)
Component (X-2): sodium dodecylbenzene sulfonate (manufactured by Tokyo Chemical Industry Co., Ltd.)
Component (C-1): water

### (Measurement of pH of the cleaning fluid)

The pH of the cleaning fluid obtained in each of Examples and Comparative Examples was measured with a pH meter (model name "D-24", manufactured by Horiba, Ltd.) while the cleaning fluid was stirred with a magnetic stirrer in a constant temperature bath at 25°C.

### (Measurement of Corrosiveness)

A silicon substrate (manufactured by Advantec Co., Ltd.) in which silicon dioxide was vapor-deposited with a film thickness of 0.3 µm was cut into 20 mm squares, and the substrate was immersed in 20 mL of the cleaning fluid obtained in each of Examples and Comparative Examples under the condition of 25°C for 4 hours. Thereafter, the substrate was taken out, and the thickness of the substrate after immersion was measured by a Spectroscopic Film Thickness Measurement System (model name "VM-1020S", manufactured by SCREEN Semiconductor Solutions Co., Ltd.). From the measured thickness of the substrate, the elution rate (Å/min) of silicon dioxide eluted in 4 hours was calculated, and the corrosiveness was evaluated.

### (Measurement of Metal Removal Property)

"ICP multi-element standard solution IV" (product name, manufactured by Merck, 23 elements in diluted nitric acid) was added to the cleaning fluid obtained in each of Examples and Comparative Examples such that the concentration of each metal was 1 ppb. The obtained cleaning fluid containing a small amount of metal was supplied to the surface of a silicon substrate (manufactured by Advantec Co., Ltd.) at 1.2 L/min while applying ultrasonic waves at 40°C for 1 minute, and the silicon substrate was washed with ultrapure water for 1 minute and spin-dried to obtain a silicon substrate for testing. The residue on the surface of the silicon substrate for testing was collected using an aqueous solution containing 0.1 mass% of hydrofluoric acid and 1 mass% of nitric acid, and the amount of metal (aluminum, iron, zinc, and lead) was measured by an Inductively Coupled Plasma Mass Spectrometry (ICP-MS, Model name "ELEMENT2", manufactured by Thermo Fisher Scientific). The metal concentration (atoms/cm²) remaining on the surface of the silicon substrate for testing was calculated, and the metal removal property was evaluated.

### (Measurement of Fine Particle Removal Property)

100 mL of a colloidal silica slurry (product name "PL-3", manufactured by Fuso Chemical Co., Ltd.) was supplied onto a silicon substrate having a diameter of 8 inches (manufactured by Advantec Co., Ltd.), and spin-drying was performed using a multi-spinner (model name "KSSP-201", manufactured by KAIJO Corporation). Thereafter, using a laser surface inspection system (model name "LS-6600", manufactured by Hitachi High-Tech Corporation), it was confirmed that a certain amount or more of silica particles of 0.06 µm or larger were adhered to the surface of the silicon substrate. The cleaning fluid obtained in each of Examples and Comparative Examples was supplied to the surface of the silicon substrate to which the silica particles were adhered, the silicon substrate was ultrasonically cleaned using a multi-spinner at 23°C for 1 minute to remove the silica particles adhering to the surface of the silicon substrate. Thereafter, the silicon substrate was washed with ultrapure water for 1 minute and spin-drying was performed to obtain a silicon substrate for testing. The number of silica particles (number of defects) of 0.06 µm or larger on the surface of the obtained silicon substrate for testing was measured using a laser surface inspection system, and the fine particle removal property was evaluated.

### [Example 1]

The components were mixed such that the component (A-1) was 0.0015 mass%, the component (B-1) was 0.3500 mass%, and the balance was the component (C-1) in 100 mass% of the cleaning fluid, to obtain a cleaning fluid.

The evaluation results of the obtained cleaning fluid are shown in Table 1.

### [Examples 2 to 4 and Comparative Examples 1 to 6]

A cleaning fluid was obtained in the same manner as in Example 1, except that the type and the content of the raw material were as shown in Table 1.

The evaluation results of the obtained cleaning fluid are shown in Table 1.

In Comparative Example 6, since the component (A-1) was insoluble in the component (C-1), the evaluation could not be performed.

**[Table 1]**

| | Component (A) | | Component (B) | | Surfactant | | pH | Elution rate (Å/min) of silicon dioxide | Residual metal concentration (atoms/cm²) | | | | Number of silica particles |
|---|---|---|---|---|---|---|---|---|---|---|---|---|---|
| | Type | Content (mass%) | Type | Content (mass%) | Type | Content (mass%) | | | Aluminum | Iron | Zinc | Lead | |
| Example 1 | (A-1) | 0.0015 | (B-1) | 0.3500 | - | - | 11.3 | 0.1 | < 0.5 | < 0.2 | 1.1 | < 0.05 | 204 |
| Example 2 | (A-1) | 0.0038 | (B-2) | 0.0250 | - | - | 11.2 | 0.0 | < 0.5 | 0.5 | < 0.2 | < 0.05 | 99 |
| Example 3 | (A-1) | 0.0038 | (B-2) | 0.0063 | - | - | 10.2 | 0.0 | < 0.5 | < 0.2 | < 0.2 | < 0.05 | 111 |
| Example 4 | (A-1) | 0.0038 | (B-2) | 0.3125 | - | - | 12.3 | 0.0 | < 0.5 | < 0.2 | < 0.2 | < 0.05 | 155 |
| Comparative Example 1 | (A'-1) | 0.0015 | (B-1) | 0.3500 | - | - | 11.3 | 0.1 | 36 | 0.6 | < 0.2 | < 0.05 | 104 |
| Comparative Example 2 | (A-1) | 0.0015 | (B-1) | 0.3500 | (X-1) | 0.0125 | 11.3 | 0.1 | < 0.5 | < 0.2 | < 0.2 | < 0.05 | 390 |
| Comparative Example 3 | (A-1) | 0.0015 | (B-1) | 0.3500 | (X-1) | 0.0625 | 11.3 | 0.1 | 0.8 | 0.3 | 0.2 | < 0.05 | 555 |
| Comparative Example 4 | (A-1) | 0.0015 | (B-1) | 0.3500 | (X-2) | 0.0125 | 11.3 | 0.1 | 0.5 | 0.3 | 0.8 | 0.08 | 569 |
| Comparative Example 5 | - | - | (B-1) | 0.3500 | - | - | 11.4 | 0.1 | 45 | 85 | 110 | 26 | 55 |
| Comparative Example 6 | (A-1) | 0.0015 | - | - | - | - | - | - | - | - | - | - | - |

As seen from Table 1, the cleaning fluids obtained in Examples 1 to 4 are excellent in metal removal property and fine particle removal property without corroding silicon.

On the other hand, the cleaning fluids obtained in Comparative Examples 2 to 4 and containing a surfactant are excellent in metal removal property but poor in fine particle removal property without corroding silicon. In addition, the cleaning fluids obtained in Comparative Examples 1 and 5 which are free of the component (A) are excellent in fine particle removal property but poor in metal removal property without corroding silicon. Further, in the Comparative Example 6 which is free of the component (B), since the component (A-1) is insoluble in the component (C-1), the evaluation cannot be performed.

### INDUSTRIAL APPLICABILITY

The cleaning fluid of the present invention is excellent in metal removal property and fine particle removal property without corroding silicon, and thus can be suitably used after polishing steps, and can be particularly preferably used after a CMP step or a backgrinding step.

## Claims

1. A cleaning fluid comprising the following components A to C and 0.001 mass% or less of a surfactant:
Component A: a compound represented by the following general formula (1);
Component B: an alkaline compound; and
Component C: water; 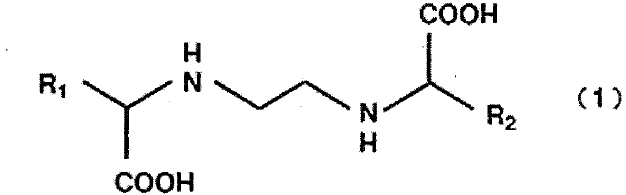
in the general formula (1), R₁ and R₂ each independently represent a hydroxyl group or a phenol group;
wherein the cleaning fluid comprises 0.0001 mass% to 10 mass% of the component A and 0.001 mass% to 50 mass% of the component B based on 100 mass% of the cleaning fluid.

2. The cleaning fluid according to claim 1, comprising 0 mass% to 0.00001 mass% surfactant.

3. The cleaning fluid according to claim 1 or 2, wherein the component A comprises ethylenediamine di-o-hydroxyphenyl acid.

4. The cleaning fluid according to any one of claims 1 to 3, wherein the component B comprises at least one selected from the group consisting of ammonia and a quaternary ammonium hydroxide.

5. The cleaning fluid according to claim 4, wherein the quaternary ammonium hydroxide comprises at least one selected from the group consisting of tetraethylammonium hydroxide, trishydroxyethylmethylammonium hydroxide, tetrabutylammonium hydroxide, triethylmethylammonium hydroxide, diethyldimethylammonium hydroxide and diethylmethylpropylammonium hydroxide.

6. The cleaning fluid according to any one of claims 1 to 5, wherein a mass ratio of the component A to the component B is from 0.001 to 0.5.

7. The cleaning fluid according to any one of claims 1 to 6, wherein a pH of the cleaning fluid is from 9 to 14.

8. A method of cleaning a semiconductor wafer comprising the step of cleaning the semiconductor wafer with the cleaning fluid of any one of claims 1 to 7.

9. A method of preparing a semiconductor wafer comprising cleaning the semiconductor wafer with the cleaning fluid of any one of claims 1 to 7.

10. The method of claim 8 or the method of claim 9, wherein the cleaning step is performed after a chemical mechanical polishing step.

11. The method of claim 8 or the method of claim 9, wherein the cleaning step is performed after a backgrinding step.

12. The method according to any one of claims 8 to 11, wherein the silicon wafer has a surface on which a compound containing silicon is exposed.

13. The method of preparing a semiconductor wafer according to claim 9, further comprising thinning the semiconductor wafer.

## Patentansprüche

1. Reinigungsflüssigkeit, umfassend die folgenden Komponenten A bis C und 0,001 Masse-% oder weniger eines Tensids:
Komponente A: eine durch die folgende allgemeine Formel (1) dargestellte Verbindung,
Komponente B: eine alkalische Verbindung und
Komponente C: Wasser, 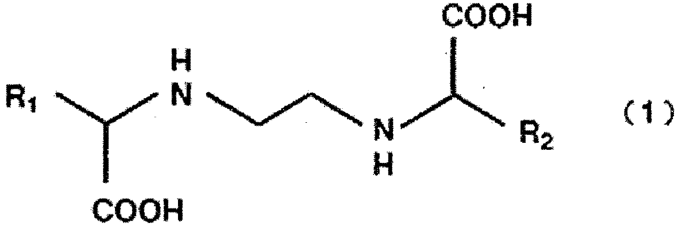
in der allgemeinen Formel (1) stellen R₁ und R₂ jeweils unabhängig eine Hydroxygruppe oder eine Phenolgruppe dar,
wobei die Reinigungsflüssigkeit 0,0001 Masse-% bis 10 Masse-% der Komponente A und 0,001 Masse-% bis 50 Masse-% der Komponente B, bezogen auf 100 Masse-% der Reinigungsflüssigkeit, umfasst.

2. Reinigungsflüssigkeit gemäß Anspruch 1, umfassend 0 Masse-% bis 0,00001 Masse-% Tensid.

3. Reinigungsflüssigkeit gemäß Anspruch 1 oder 2, wobei die Komponente A Ethylendiamin-di-o-hydroxyphenylsäure umfasst.

4. Reinigungsflüssigkeit gemäß einem der Ansprüche 1 bis 3, wobei die Komponente B mindestens eines, ausgewählt aus der Gruppe, bestehend aus Ammoniak und einem quaternärem Ammoniumhydroxid, umfasst.

5. Reinigungsflüssigkeit gemäß Anspruch 4, wobei das quaternäre Ammoniumhydroxid mindestens eines, ausgewählt aus der Gruppe, bestehend aus Tetraethylammoniumhydroxid, Trishydroxyethylmethylammoniumhydroxid, Tetrabutylammoniumhydroxid, Triethylmethylammoniumhydroxid, Diethyldimethylammoniumhydroxid und Diethylmethylpropylammoniumhydroxid, umfasst.

6. Reinigungsflüssigkeit gemäß einem der Ansprüche 1 bis 5, wobei ein Massenverhältnis der Komponente A zu der Komponente B 0,001 bis 0,5 beträgt.

7. Reinigungsflüssigkeit gemäß einem der Ansprüche 1 bis 6, wobei ein pH-Wert der Reinigungsflüssigkeit 9 bis 14 beträgt.

8. Verfahren zur Reinigung eines Halbleiterwafers, umfassend den Schritt des Reinigens des Halbleiterwafers mit der Reinigungsflüssigkeit nach einem der Ansprüche 1 bis 7.

9. Verfahren zur Herstellung eines Halbleiterwafers, umfassend das Reinigen des Halbleiterwafers mit der Reinigungsflüssigkeit nach einem der Ansprüche 1 bis 7.

10. Verfahren nach Anspruch 8 oder Verfahren nach Anspruch 9, wobei der Reinigungsschritt nach einem chemischmechanischen Polierschritt durchgeführt wird.

11. Verfahren nach Anspruch 8 oder Verfahren nach Anspruch 9, wobei der Reinigungsschritt nach einem Rückschleifschritt durchgeführt wird.

12. Verfahren gemäß einem der Ansprüche 8 bis 11, wobei der Siliciumwafer eine Oberfläche aufweist, auf der eine Verbindung, die Silicium enthält, exponiert ist.

13. Verfahren zur Herstellung eines Halbleiterwafers gemäß Anspruch 9, ferner umfassend das Dünnen des Halbleiterwafers.

## Revendications

1. Fluide de nettoyage comprenant les composants suivants A à C et 0,001 % en masse ou moins d'un tensioactif :
Composant A : un composé représenté par la formule générale suivante (1) ;
Composant B : un composé alcalin ; et
Composant C : de l'eau ; 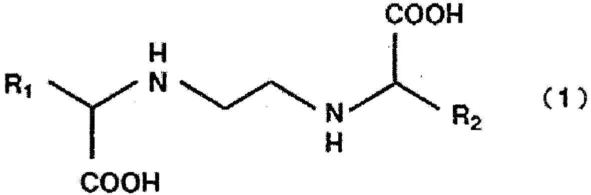
dans la formule générale (1), R₁ et R₂ représentent chacun indépendamment un groupe hydroxyle ou un groupe phénol ;
dans lequel le fluide de nettoyage comprend de 0,0001 % en masse à 10 % en masse du composant A et de 0,001 % en masse à 50 % en masse du composant B sur la base de 100 % en masse du fluide de nettoyage.

2. Fluide de nettoyage selon la revendication 1, comprenant de 0 % en masse à 0,00001 % en masse de tensioactif.

3. Fluide de nettoyage selon la revendication 1 ou 2, dans lequel le composant A comprend de l'acide éthylènediamine di-o-hydroxyphényle.

4. Fluide de nettoyage selon l'une quelconque des revendications 1 à 3, dans lequel le composant B comprend au moins un élément sélectionné dans le groupe constitué d'ammoniac et d'hydroxyde d'ammonium quaternaire.

5. Fluide de nettoyage selon la revendication 4, dans lequel l'hydroxyde d'ammonium quaternaire comprend au moins un élément sélectionné dans le groupe constitué d'hydroxyde de tétraéthylammonium, hydroxyde de trishydroxyéthylméthylammonium, hydroxyde de tétrabutylammonium, hydroxyde de triéthylméthylammonium, hydroxyde de diéthyldiméthylammonium et hydroxyde de diéthylméthylpropylammonium.

6. Fluide de nettoyage selon l'une quelconque des revendications 1 à 5, dans lequel le rapport massique du composant A sur le composant B est compris de 0,001 à 0,5.

7. Fluide de nettoyage selon l'une quelconque des revendications 1 à 6, dans lequel un pH du fluide de nettoyage est compris de 9 à 14.

8. Procédé de nettoyage d'une tranche de semi-conducteur comprenant l'étape de nettoyage de la tranche de semi-conducteur avec le fluide de nettoyage selon l'une quelconque des revendications 1 à 7.

9. Procédé de préparation d'une tranche de semi-conducteur comprenant le nettoyage de la tranche de semi-conducteur avec le fluide de nettoyage selon l'une quelconque des revendications 1 à 7.

10. Procédé selon la revendication 8 ou procédé selon la revendication 9, dans lequel l'étape de nettoyage est mise en oeuvre après une étape de polissage chimico-mécanique.

11. Procédé selon la revendication 8 ou procédé selon la revendication 9, dans lequel l'étape de nettoyage est mise en oeuvre après une étape de meulage arrière.

12. Procédé selon l'une quelconque des revendications 8 à 11, dans lequel la tranche de silicium présente une surface sur laquelle un composé contenant du silicium est exposé.

13. Procédé destiné à préparer une tranche de semi-conducteur selon la revendication 9, comprenant en outre l'amincissement de la tranche de semi-conducteur.
